# EUROPEAN PATENT SPECIFICATION

(11) **EP 1 197 128 B1**
(45) Date of publication and mention of the grant of the patent: **23.05.2007**
(21) Application number: 00946643.4
(22) Date of filing: 26.06.2000
(51) Int. Cl.: H05K 1/02, H05K 7/20

(54) **Thermal vias arranged in a printed circuit board to conduct heat away from surface mounted components through the board**
Wärmedurchgangslöcher in einer Leiterplatte, um Wärme von oberflächenmontierten elektronischen Bauteilen weg durch die Leiterplatte zu leiten
Traversées thermiques arrangées dans un circuit imprimé pour évacuer à travers la carte la chaleur issue de composants montés en surface

(30) Priority: 30.06.1999 SE 9902496
(43) Date of publication of application: 17.04.2002
(73) Proprietor: Infineon Technologies AG, 81669 München (DE)
(72) Inventor: OLOFSSON, Lars-Anders, S-175 43 Järfälla (SE)
(74) Representative: Karlsson, Leif Karl Gunnar
(86) International application number: PCT/SE2000/001349
(87) International publication number: WO 2001/001738

(56) References cited:
- DE-A1- 1 953 992
- DE-A1- 3 619 226
- DE-A1- 4 220 966
- US-A- 5 779 134

## Description

### FIELD OF INVENTION

The present invention relates to a printed circuit board that includes thermal vias.

### BACKGROUND OF THE INVENTION

When surface soldering power components, such as RF-power transistors for instance, it is necessary to improve thermal conduction in the board with the aid of thermal vias. This is because the actual board material, which is often a polymeric material, has very low thermal conductivity, about 0.5 W/m°C, whereas the metallic material has a thermal conductivity of about 400 W/m°C, which is a factor of 800 in this particular case.

The thermal vias are at present formed by drilling a number of holes in the board material, on the surface on which the component body shall be soldered. The inner surfaces of these vias are coated with a thin metallic layer, normally a copper layer in the following stages of board manufacture. It is chiefly this thin copper layer that conducts heat through the board.

One problem with present day thermal vias is that the solder that shall join the component body to the board penetrates down into the holes, therewith draining the soldering location of the solder required to effect the bond, and forms solder droplets on the opposite side of the board relative to the component body. The problem with these solder droplets is that they considerably impair the thermal contact between an underside of the board and a cooler, and it is therefore necessary to remove these droplets in one way or another.

DE 4 220 966 relates to metal plugs extending through holes formed in a board for conducting heat away from components mounted on the board. The metal plugs are deformed against the walls of the holes.

### SUMMARY OF THE INVENTION

One object of the present invention is to at least reduce the aforesaid problem.

According to a first aspect of the present invention this object is achieved with,a printed circuit board according to Claim 1.

One advantage afforded by the present invention is that the printed circuit boards have a considerably lower thermal resistance from an upper side to a lower side of said boards in comparison with boards that are manufactured in accordance with present day technology.

Another advantage afforded by the present invention is that probing of the vias is simplified when they are fully closed.

Another advantage afforded by the present invention is that power components can be surface mounted at the same time as all other components are surface mounted on the board, which considerably lowers costs in relation to traditional manual mounting processes.

Still another advantage afforded by the present invention is that the cooler or chassi need not fulfil the high requirements of surface flatness, since components, such as RF-power transistors, can be surface soldered directly onto the printed circuit board.

The invention will now be described in more detail with reference to exemplifying embodiments thereof and also with reference to the accompanying drawings.

### BRIEF DESCRIPTION OF THE DRAWINGS

Figure 1 is a side view of a board for the manufacture of a printed circuit board.
Figure 2 shows from above a board provided with holes and intended for the manufacture of a printed circuit board.
Figure 3 is a side view of an inventive board into which thermal vias have been firmly pressed and which is intended for the manufacture of a printed circuit board.

### DESCRIPTION OF PREFERRED EMBODIMENTS

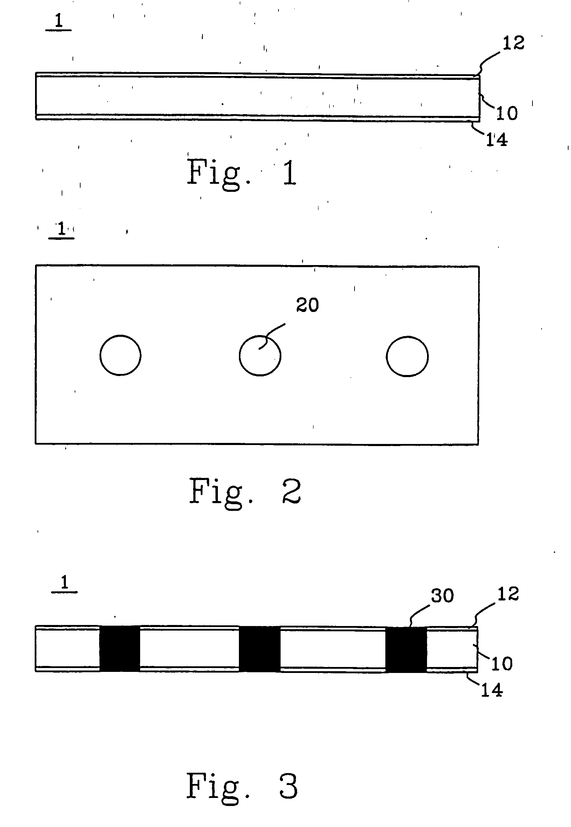

Figure 1 is a side view of a board 1 intended for the manufacture of a printed circuit board. The board 1 includes board material 10 on which there has been disposed a metallized top and bottom surface 12 and 14 respectively. The metallized top and bottom sides form basis for the conductor pattern, i.e. the conductor pattern is etched from the electrically conductive top and bottom sides by methods which are well known to the person skilled in this art and which do not therefore need to be described in detail in this document. The board material is some suitable, commercially available material, such as FR4 or BT for instance.
Figure 2 shows from above a board 1 that includes three holes 20. The size and the shape of the holes 20 are adapted to accommodate metallic plugs that are to be pressed into the holes.

Figure 3 is a side view of a printed circuit board 1 in which metallic plugs 30 have been pressed into said holes. The metallic plugs are pressed into the board material and compressed or upset axially, such as to cause the plugs to expand in a direction orthogonally to the longitudinal direction of respective holes 20. Expansion of the plugs 30 causes the plugs to be urged outwards against an inner wall surface of the metallic layer 12 and 14 on respective top and bottom sides of the board material 10. The plugs form thermal vias in the board 1 and also form a tight surface with the peripheral metallic layers 12 and 14. In order to improve the final result in the subsequent lithographic patterning of a conductor pattern and the following etching process, it may be necessary to smooth down the top and bottom sides of the board, so as to eliminate any differences in heights between the metallic layers 12 and 14 and the plug 30.

The plugs 30 are preferably made of copper. Although the plug-receiving holes 20 in the board will preferably be circular in shape, they may, alternatively, be rectangular, triangular or elliptical in shape. The shape and size of respective plugs 30 are adapted to the shape and size of respective holes 20 in the board. The holes will preferably contain no sharp corners.

Thermal conductivity can be further improved by placing an additional copper layer on the bottom and/or the top side of the board prior to creating said conductor pattern. The presence of such an additional layer will ensure that chemicals do not penetrate into any possible cracks between the plug and the hole, in the following process stages.

Although the board illustrated in the figures is a two-layer board, it will be understood that the present invention can also be applied to single-layer boards or boards that comprise more than two layers. In the case of boards that include more than two layers, the plugs will seal against an inner wall surface of the metallic layer 12 and 14 on respective top and bottom sides of the board material 10 and not against the metallic layer or layers within the board.

It will be understood that the invention is not restricted to the aforedescribed and illustrated exemplifying embodiments thereof and that modifications can be made within the scope of the following claims.

## Claims

1. A printed circuit board with one or more metal plugs (30) extending through holes (20) in the board (10) for conducting heat from components mounted on the board, **characterized in that** the holes (20) extend through metallizations (12, 14) on the top and bottom sides of the board (10) and that the metal plugs (30) are deformed to seal against the walls of the holes through the metallizations (12, 14) of the board

2. The printed circuit board according to claim 1,
**characterized in that** a metallic layer is provided on top of and adjacent to the metal plugs on the top side and/or bottom side of the board.

## Patentansprüche

1. Leiterplatte mit einem oder mehreren Metallstopfen (30), die sich zur Leitung von Wärme von auf der Platte montierten Komponenten durch Löcher (20) in der Platte (10) erstrecken, **dadurch gekennzeichnet, dass** die Löcher (20) sich durch Metallisierungen (12, 14) auf den Ober- und Unterseiten der Platte (10) erstrecken und dass die Metallstopfen (30) deformiert sind, um gegen die Wände der Löcher durch die Metallisierungen (12, 14) der Platte abzudichten.

2. Leiterplatte nach Anspruch 1, **dadurch gekennzeichnet, dass** eine metallische Schicht auf und angrenzend an die Metallstopfen auf der Oberseite und/oder der Unterseite der Platte vorhanden ist.

## Revendications

1. Une carte à circuit imprimé avec une ou plusieurs fiches de métal (30) s'étendant au travers de trous (20) dans la carte (10) pour la conduction de chaleur à partir des composants montés sur la carte, **caractérisée en ce que** les trous (20) s'étendent au travers de métallisations (12, 14) sur les faces supérieure et inférieure de la carte (10) et **en ce que** les fiches de métal (30) sont déformées pour sceller contre les parois des trous au travers des métallisations (12, 14) de la carte.

2. La carte à circuit imprimé selon la revendication 1, **caractérisée en ce qu'**une couche métallique est pourvue par-dessus et adjacente aux fiches de métal sur la face supérieure et/ou la face inférieure de la carte.
